# DEMANDE DE BREVET EUROPEEN

(11) **EP 4 704 343 A2**
(43) Date de publication de la demande: **04.03.2026**
(21) Numéro de dépôt: 25198011.6
(22) Date de dépôt: 26.08.2025
(51) Int. Cl.: H03K 17/06, H02M 1/08, H03K 19/0185, H10B 80/00, H02M 3/158

(54) **CONVERTISSEUR**

(30) Priorité: 29.08.2024 FR 2409216
(71) Demandeur: STMicroelectronics International N.V., 1228 Plan-les-Ouates, Geneva (CH)
(72) Inventeur: BOURGUINE, Loic, 13790 Chateauneuf Le Rouge (FR)
(74) Mandataire: Cabinet Beaumont

(57) **Abrégé**

La présente description concerne un convertisseur de tension (400) formé sur un substrat recouvert de GaN, comprenant :
- une première puce (401) comportant un premier transistor (T401) e-mode et un premier circuit de commande (D401) dudit premier transistor ; et
- une deuxième puce (402) comportant un deuxième transistor (T402) e-mode et un deuxième circuit de commande (D402) dudit deuxième transistor, et étant adapté à transmettre ladite première tension reçue de la part d'un troisième circuit de commande (410) à ladite deuxième puce;

dans lequel ladite deuxième puce comprend un convertisseur de tension adapté à convertir ladite première tension en une deuxième tension,
ledit convertisseur de tension comprenant une première source de courant utilisée lorsqu'une tension de sortie dudit convertisseur (400) est inférieure à une tension de seuil, et une deuxième source de courant utilisée lorsque ladite tension de sortie est supérieure à ladite tension de seuil.

## Description

### Domaine technique

La présente description concerne de façon générale les systèmes et dispositifs électroniques, et en particulier la conversion de tension au sein d'un système ou d'un dispositif électronique. La présente description se rapporte plus particulièrement à un convertisseur formé dans et sur une structure comprenant du Nitrure de Gallium (GaN).

### Technique antérieure

Il est classique de former des systèmes et des dispositifs électroniques à partir de substrat en silicium, mais d'autres matériaux semiconducteurs peuvent être utilisés. En particulier, des structures comprenant du Nitrure de Gallium (GaN) peuvent être utilisées.

Il serait souhaitable de pouvoir améliorer, au moins en partie, certains aspects des systèmes et dispositifs électroniques formées à partir dans et sur des structures comprenant du Nitrure de Gallium.

### Résumé de l'invention

Il existe un besoin pour des systèmes et dispositifs électroniques formés dans et sur des structures comprenant du Nitrure de Gallium.

Il existe un besoin pour des convertisseurs de tension formés dans et sur des structures comprenant du Nitrure de Gallium.

Un mode de réalisation pallie tout ou partie des inconvénients des convertisseurs de tension connus formés dans et sur des structures comprenant du Nitrure de Gallium.

Un mode de réalisation prévoit un convertisseur de tension formés dans et sur des structures comprenant du Nitrure de Gallium plus performant.

Un mode de réalisation prévoit un convertisseur de tension présentant un structure de type demi-pont plus performante.

Un mode de réalisation prévoit un convertisseur de tension comprenant deux puces, une première puce étant adaptée à traiter des tensions basses et une deuxième puce adaptée à traiter des tensions hautes.

Un mode de réalisation prévoit un tel convertisseur dans lequel des tensions de commande ne sont fournies qu'à la première puce, ces tensions de commande sont transmises à la deuxième via la première puce.

Selon un premier aspect, un mode de réalisation prévoit un convertisseur de tension comprenant un circuit de décalage de tension permettant de transmettre les tensions de commande de la première puce à la deuxième puce plus performant.

Un mode de réalisation prévoit un tel convertisseur de tension utilisant plusieurs sources de courant en fonction de la valeur d'une tension de sortie du convertisseur.

Selon un deuxième aspect, un mode de réalisation prévoit un circuit permettant de convertir des signaux haute tension en des signaux basse tension.

Selon un troisième aspect, un mode de réalisation prévoit un convertisseur de tension formé à partir de deux puces identiques configurables pouvant chacune être la première ou la deuxième puce.

Un mode de réalisation prévoit un convertisseur de tension formé dans et sur un substrat semiconducteur monolithique ayant une face recouverte d'une couche de Nitrure de Gallium, comprenant :
- une première puce comportant un premier transistor de puissance HEMT de type e-mode et un premier circuit de commande dudit premier transistor ; et
- une deuxième puce comportant un deuxième transistor de puissance HEMT de type e-mode et un deuxième circuit de commande dudit deuxième transistor, et étant adapté à transmettre au moins une première tension reçue de la part d'un troisième circuit de commande à ladite deuxième puce ; dans lequel ladite deuxième puce comprend un premier circuit décaleur de tension adapté à convertir ladite au moins une première tension en une deuxième tension,
   ledit premier circuit décaleur de tension comprenant une première source de courant adaptée à être utilisée lorsqu'une troisième tension de sortie dudit convertisseur est inférieure à une quatrième tension de seuil, et une deuxième source de courant adaptée à être utilisée lorsque ladite troisième tension de sortie est supérieure à ladite quatrième tension de seuil.

Selon un mode de réalisation, les première et deuxième sources de courant sont utilisées pour fournir une tension de commande audit premier transistor.

Selon un mode de réalisation, ladite quatrième tension de seuil est comprise entre -5 et 0 V.

Selon un mode de réalisation, ladite quatrième tension de seuil est égale à -2 V.

Selon un mode de réalisation, la première puce est adaptée à recevoir des hautes tensions, et la deuxième puce est adaptée à recevoir des basses tensions.

Selon un mode de réalisation, ladite première puce comprend, en outre, un quatrième circuit adaptateur de tension adapté à convertir au moins une cinquième tension de ladite première puce en une sixième tension de diagnostic pour la transmettre à ladite deuxième puce,
ledit quatrième circuit adaptateur de tension comprenant un oscillateur étant configuré pour faire osciller ladite sixième tension lorsque ladite cinquième tension est à un premier état.

Selon un mode de réalisation, ledit oscillateur étant configuré pour ne pas faire osciller ladite sixième tension lorsque ladite cinquième tension est à un deuxième état différent du premier état.

Selon un mode de réalisation, lesdites première et deuxième puces sont des puces identiques.

Selon un mode de réalisation, lesdites première et deuxième puces comprennent chacune une borne de configuration leur permettant de définir leur rôle dans ledit convertisseur.

Selon un mode de réalisation, le convertisseur est une alimentation à découpage.

Selon un mode de réalisation, le convertisseur est une alimentation à découpage de type convertisseur boost.

Un autre mode de réalisation prévoit un procédé de conversion d'une septième tension d'entrée en une troisième tension de sortie utilisant un convertisseur de tension formé dans et sur un substrat semiconducteur monolithique ayant une face recouverte d'une couche de Nitrure de Gallium, comprenant :
- une première puce comportant un premier transistor de puissance HEMT de type e-mode et un premier circuit de commande dudit premier transistor ; et
- une deuxième puce comportant un deuxième transistor de puissance HEMT de type e-mode et un deuxième circuit de commande dudit deuxième transistor, et étant adapté à transmettre au moins une première tension reçue de la part d'un troisième circuit de commande à ladite deuxième puce ; dans lequel ladite deuxième puce comprend un premier circuit adaptateur de tension adapté à convertir ladite au moins une première tension en une deuxième tension,
   ledit premier circuit décaleur de tension comprenant une première source de courant adaptée à être utilisée lorsqu'une troisième tension de sortie dudit convertisseur est inférieure à une quatrième tension de seuil, et une deuxième source de courant adaptée à être utilisée lorsque ladite troisième tension de sortie est supérieure à ladite quatrième tension de seuil.

Un autre mode de réalisation prévoit un procédé de fabrication d'un convertisseur de tension comprenant :
- une première puce comportant un premier transistor de puissance HEMT de type e-mode et un premier circuit de commande dudit premier transistor ; et
- une deuxième puce comportant un deuxième transistor de puissance HEMT de type e-mode et un deuxième circuit de commande dudit deuxième transistor,
   comprenant deux étapes de fabrication identiques des première et deuxième puces.

Selon un mode de réalisation, le procédé comprend, en outre, une étape de configuration des première et deuxième puces qui est successive aux deux étapes de fabrication.

Selon un mode de réalisation, pendant l'étape de configuration une borne de configuration desdites première et deuxième puces est utilisée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
La figure 1 représente, très schématiquement, une structure comprenant du Nitrure de Gallium ;
la figure 2 comprend deux vues (A) et (B) illustrant un premier type de transistor formé dans et sur une structure comprenant du Nitrure de Gallium ;
la figure 3 représente comprend deux vues (A) et (B) illustrant un deuxième type de transistor formé dans une structure comprenant du Nitrure de Gallium ;
la figure 4 représente, schématiquement et sous forme de blocs, un mode de réalisation d'un convertisseur de tension ;
la figure 5 représente un exemple pratique du mode de réalisation de la figure 4 ;
la figure 6 représente un mode de réalisation d'une partie du convertisseur de la figure 4 ;
la figure 7 représente un mode de réalisation d'un circuit décaleur de tension du mode de réalisation de la figure 6 ;
la figure 8 représente, plus en détail un mode de réalisation d'un circuit décaleur de tension du mode de réalisation de la figure 6 ;
la figure 9 représente un autre circuit convertisseur de tension du mode de réalisation de la figure 6 ; et
la figure 10 représente, très schématiquement, un mode de réalisation pratique du mode de réalisation de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

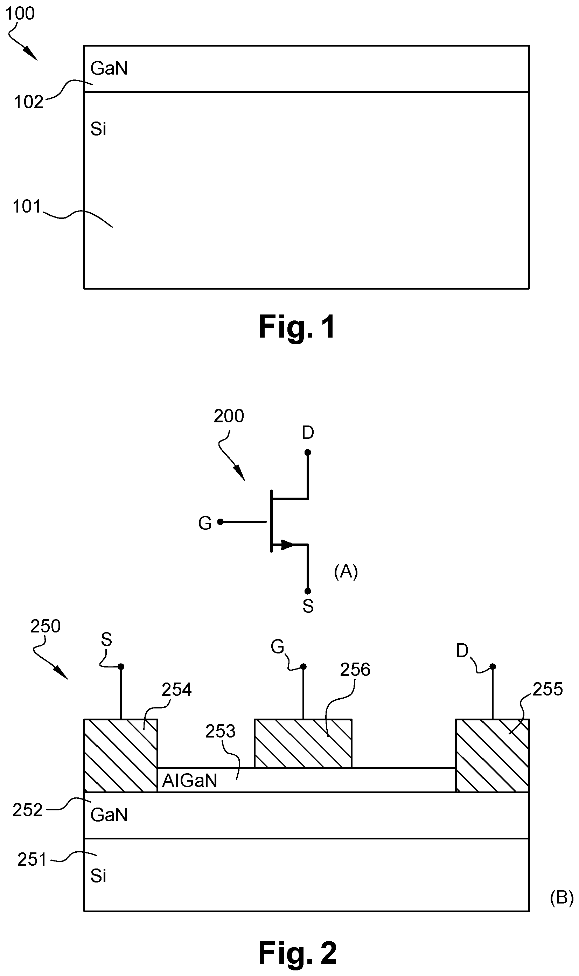

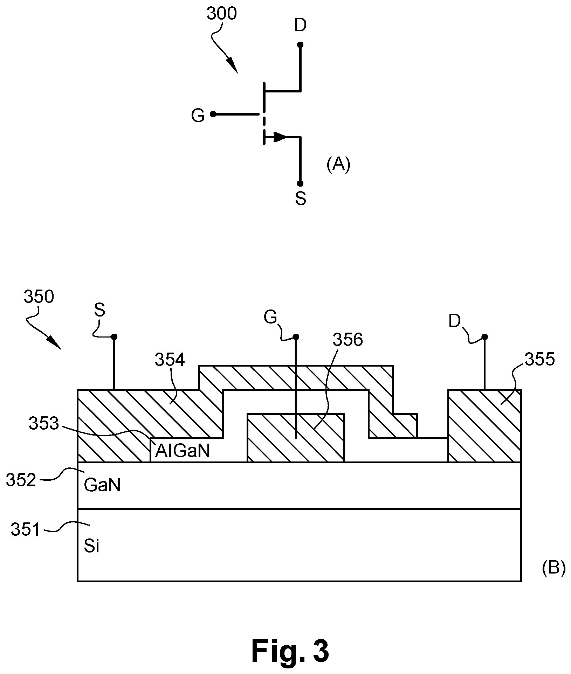

Les modes de réalisation décrits ci-après se rapportent à des systèmes et dispositifs électroniques formés dans et sur des structures comprenant du Nitrure de Gallium, un exemple d'une telle structure est décrit en relation avec la figure 1. L'utilisation de telles structures ne permet pas l'utilisation des composants électroniques classiques, et en particulier, ne permet l'utilisation de composants électroniques utilisant des jonctions PN comme des diodes, des transistors de type MOSFET, etc. En revanche, des transistors à haute mobilité d'électrons peuvent être employés. Deux types de ces transistors sont décrits en relation avec les figures 2 et 3.

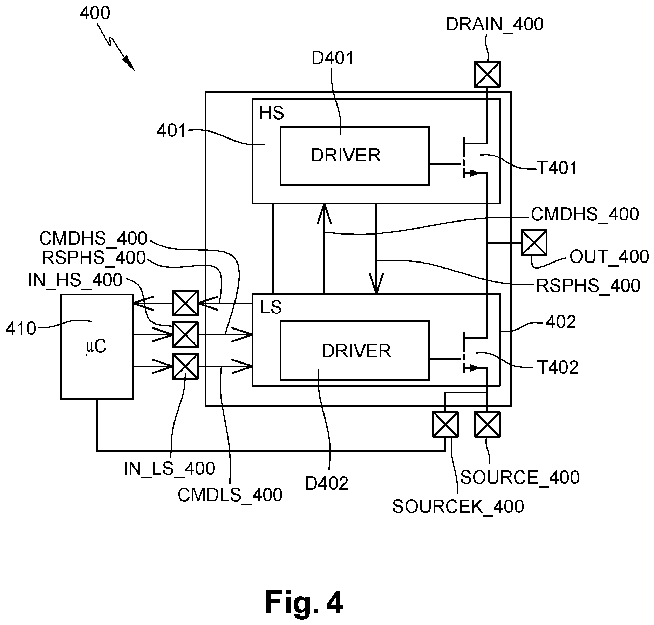

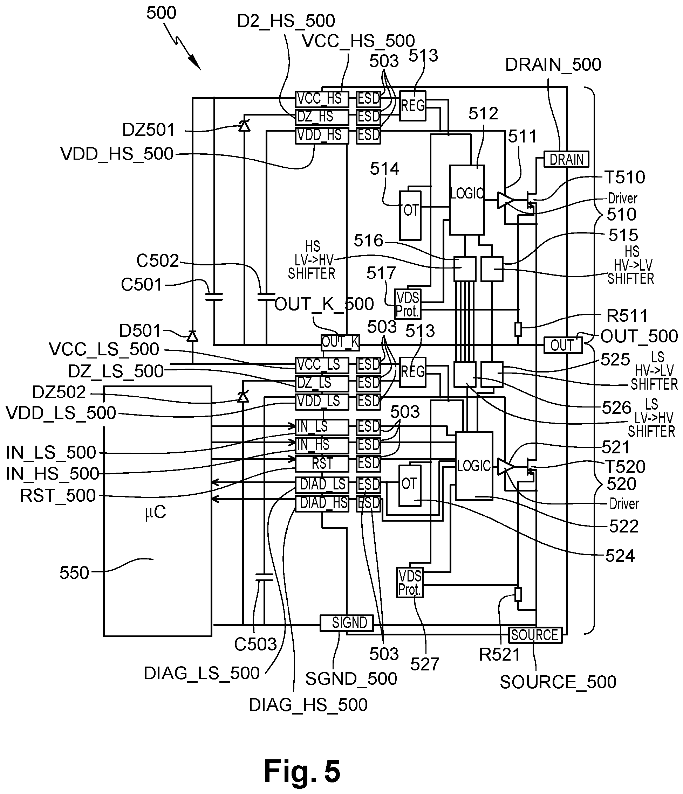

Les modes de réalisation décrits ci-après concernent plus particulièrement un convertisseur de tension formé dans et sur de telles structures. Plus précisément, il s'agit ici d'un convertisseur de tension utilisant une structure de type demi-pont (half-bridge), décrite en relation avec les figures 4 et 5. Un premier aspect de ces modes de réalisation concerne un circuit décaleur de tension, ou circuit de décalage de tension, permettant de transmettre des tensions depuis un puce basse tension à une puce haute tension. Un deuxième aspect de ces modes de réalisation concerne un circuit de conversion permettant de transmettre des signaux depuis la puce haute tension vers la puce basse tension. Un troisième aspect de ces modes de réalisation concerne un exemple pratique de réalisation d'un convertisseur de tension et son procédé de fabrication.

De plus, les modes de réalisation décrits ci-dessus sont particulièrement adaptés pour être utilisés dans tout type de marchés industriels où une conversion de tension est nécessaire. Plus particulièrement, un tel circuit convertisseur de tension peut être destiné à :
- l'industrie automobile, par exemple dans le domaine de l'électrification automobile ou dans le domaine des systèmes avancés d'aide à la conduite (Advanced Driver Assistance Systems - ADAS) ;
- l'industrie industrielle, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

Plus particulièrement, ces modes de réalisation peuvent être utilisés dans l'industrie automobile pour de la conversion d'énergie. Plus précisément, ces convertisseurs de tensions peuvent être utilisé dans des chargeurs de batterie de véhicules, et des chargeurs de véhicules électriques.

La figure 1 est une vue en coupe représentant très schématiquement une structure semiconductrice 100 comprenant du Nitrure de Gallium.

La structure 100 est généralement composée d'un substrat 101 (Si) en un matériau semiconducteur, par exemple un substrat en silicium, recouvert sur une de ses faces d'une couche 102 (GaN) en Nitrure de Gallium (GaN). La couche 102 a une épaisseur comprise entre 0,5 et 5 µm.

Lorsque la structure 100 est utilisée comme base d'un système ou d'un dispositif électronique, des composants électroniques sont formées dans et sur la couche 102. Des niveaux de métallisations peuvent, en outre, être formés sur la couche 102.

La figure 2 comprend deux vues (A) et (B) illustrant un premier type de transistor 200 formé dans une structure comprenant du Nitrure de Gallium. La vue (A) représente un schéma électrique du transistor 200, et la vue (B) représente une vue en coupe d'une structure 250 formant le transistor 200.

Le transistor 200 est un transistor à électron à haute mobilité (High Electron Mobility Transistor, HEMT), aussi appelé transistor à effet de champ à dopage modulé (modulated-doping field effect transistor, MODFET). Ci-après un transistor à élection à haute mobilité est appelé transistor HEMT.

Un transistor HEMT, comme le transistor 200, comprend, une borne de grille, notée G en figure 2, une borne de source, notée S en figure 2, et une borne de drain, notée D en figure 2.

De plus, le transistor 200 est un transistor HEMT à mode de déplétion (depletion mode), appelé ci-après transistor HEMT de type d-mode, ou transistor d-mode. Selon une autre appellation, le transistor 200 est un transistor HEMT de type normalement ON (normally-ON), ou transistor HEMT normalement ON, ou transistor normalement ON. Le schéma électrique du transistor 200 présenté en vue (A) est le schéma électrique qui sera utilisé dans toutes les figures suivantes pour représenter un transistor d-mode ou normalement ON.

En pratique, le transistor 200 peut être obtenu par une structure 250 formée à partir d'une structure du type de la structure 100 décrite en relation avec la figure 1. Ainsi, la structure 250 comprend un substrat 251 (Si) en un matériau conducteur, comme du silicium, dont une face est recouverte par une couche 252 (GaN) en Nitrure de Gallium. La couche 252 en Nitrure de Gallium est partiellement recouverte par une couche 253 (AlGaN) en Nitrure d'Aluminium-Gallium. Une borne de connexion 254 forme la prise de contact de source S du transistor 200. La borne de connexion 254 est formée sur une portion de la couche 252 qui n'est pas recouverte de la couche 253. Une borne de connexion 255 forme la prise de contact de drain D du transistor 200. La borne de connexion 255 est formée sur une portion de la couche 252 qui n'est pas recouverte de la couche 253. Une borne de connexion 256 forme la prise de contact de grille G du transistor 200. La borne de connexion 256 est formée sur une portion de la couche 253, et est disposé entre les plots de connexion 254 et 255.

Le fonctionnement du transistor 200 est le suivant. Lorsque la grille G du transistor 200 est laissé flottante ou qu'une tension positive est appliquée entre sa grille G et sa source S, le transistor 200 est passant au conducteur, d'où son appellation de transistor normalement ON. Pour "fermer" le transistor 200, c'est-à-dire le rendre non conducteur, une tension négative doit être appliquée entre sa grille G et sa source S.

La figure 3 comprend deux vues (A) et (B) illustrant un deuxième type de transistor 300 formé dans une structure comprenant du Nitrure de Gallium. La vue (A) représente un schéma électrique du transistor 300, et la vue (B) représente une vue en coupe d'une structure 350 formant le transistor 300.

Comme le transistor 200 décrit en relation avec la figure 2, le transistor 300 est un transistor à électron à haute mobilité, ou transistor HEMT. Le transistor 300, comprend, une borne de grille, notée G en figure 3, une borne de source, notée S en figure 3, et une borne de drain, notée D en figure 3.

De plus, et à l'inverse du transistor 200 de la figure 2, le transistor 300 est un transistor HEMT à mode de renforcement (enhancement mode), appelé ci-après transistor HEMT de type e-mode, ou transistor e-mode. Selon une autre appellation, le transistor 300 est un transistor HEMT de type normalement OFF (normally-OFF), ou transistor HEMT normalement OFF, ou transistor normalement OFF. Le schéma électrique du transistor 300 présenté en vue (A) est le schéma électrique qui sera utilisé dans toutes les figures suivantes pour représenter un transistor e-mode ou normalement OFF.

En pratique, le transistor 300 peut être obtenu par une structure 350 formée à partir d'une structure du type de la structure 100 décrite en relation avec la figure 1. Ainsi, la structure 350 comprend un substrat 351 (Si) en un matériau conducteur, comme du silicium, dont une face est recouverte par une couche 352 (GaN) en Nitrure de Gallium. La couche 352 en Nitrure de Gallium est partiellement recouverte par une couche 353 (AlGaN) en Nitrure d'Aluminium-Gallium. Une borne de connexion 354 forme la prise de contact de source S du transistor 300. La borne de connexion 354 est formée sur une portion de la couche 352 qui n'est pas recouverte de la couche 353. Une borne de connexion 355 forme la prise de contact de drain D du transistor 300. La borne de connexion 355 est formée sur une portion de la couche 352 qui n'est pas recouverte de la couche 353. Une borne de connexion 356 forme la prise de contact de grille G du transistor 300. La borne de connexion 356 est formée entre la couche 352 et la couche 353 et est disposé entre les plots de connexion 354 et 355. De plus, une portion du plot de connexion 354 recouvre la portion de la couche 353 recouvrant la plot de connexion 356 comme représenté en vue (B) de la figure 3.

Le fonctionnement du transistor 300 est le suivant. Lorsque la grille G du transistor 300 est laissé flottante ou qu'une tension négative est appliquée entre sa grille G et sa source S, le transistor 300 n'est pas conducteur ou non passant, d'où son appellation de transistor normalement OFF. Pour "ouvrir" le transistor 300, c'est-à-dire le rendre conducteur, une tension positive doit être appliquée entre sa grille G et sa source S.

La figure 4 représente un mode de réalisation d'un convertisseur de tension 400 et de son circuit de commande externe 410 (µC).

Le convertisseur de tension 400, ou circuit convertisseur de tension, est adapté à convertir une première tension reçue en une deuxième tension fournie entre une borne OUT_400 et la borne de référence SOURCE_400. Selon un exemple, le convertisseur 400 est une alimentation à découpage, par exemple une alimentation à découpage de type convertisseur boost. Plus particulièrement, le convertisseur de tension 400 présente une structure en demi-pont (halfbridge), c'est-à-dire une structure utilisant deux transistors de puissance disposés en série et leurs circuits de pilotage.

Selon un mode de réalisation, le convertisseur 400 comprend au moins deux puces, une puce 401 (HS) recevant des hautes tensions et une puce 402 (LS) recevant des basses tensions. La puce 401 est aussi appelée puce haute tension, et la puce 402 est aussi appelée puce basse tension. On appelle ici des basses tensions, des tensions comprises en 0 et 20 V, de préférence comprise entre 5 et 15 V. On appelle ici des hautes tensions, des tensions supérieures à 350 V, de préférence comprise entre 400 et 650 V.

La puce 401 comprend un transistor de puissance T401 HEMT de type e-mode. Une borne de drain du transistor T401 est reliée, de préférence connectée, à une borne DRAIN_400 du convertisseur 400. Une borne de source du transistor T401 est reliée, de préférence connectée, à la borne OUT_400 du convertisseur 400.

La puce 401 comprend, en outre, un circuit de pilotage D401 (DRIVER) du transistor T401. Une borne de sortie du circuit de pilotage D401 est reliée, de préférence connectée, à la borne de grille du transistor T401.

La puce 402 comprend un transistor de puissance T402 HEMT de type e-mode. Une borne de drain du transistor T402 est reliée, de préférence connectée, à une borne OUT_400 du convertisseur 400. Une borne de source du transistor T402 est reliée, de préférence connectée, à la borne SOURCE _400 du convertisseur 400.

La puce 402 comprend, en outre, un circuit de pilotage D402 (DRIVER) du transistor T402. Une borne de sortie du circuit de pilotage D402 est reliée, de préférence connectée, à la borne de grille du transistor T402.

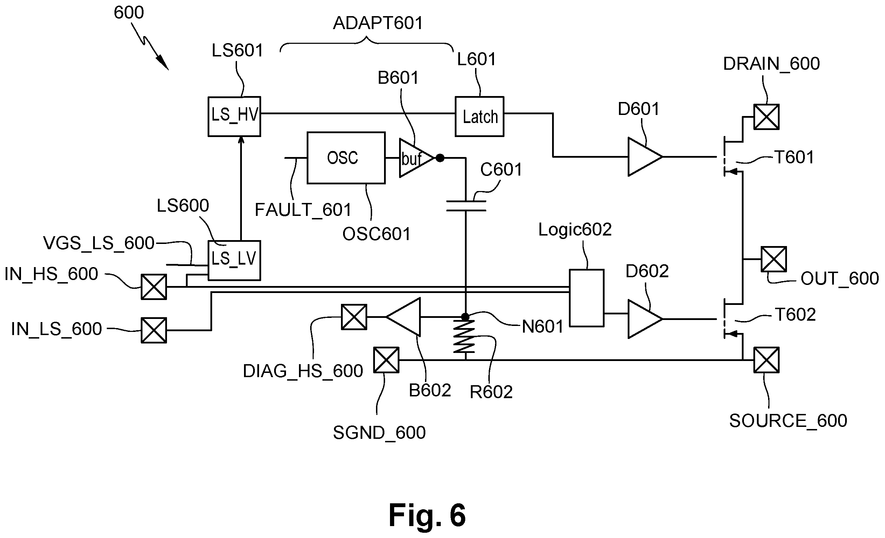

Le convertisseur 400 est adapté à être commandé par le circuit de commande 410. Selon un mode de réalisation, le circuit de commande 410 est adapté à fournir des tensions de commande destinées aux puces 401 et 402 du convertisseur 400, mais n'est relié qu'à la puce 402. Plus particulièrement, la puce 402 comprend une borne IN_LS_400 destinée à recevoir des tensions de commande CMDLS_400 pour elle-même, et une borne IN_HS_400 destinée à recevoir des tensions de commande CMDLS_400 pour la puce 401. Selon un mode de réalisation, la puce 401 comprend des circuits permettant d'adapter les niveaux de tensions des tensions de commande CMDHS_400 du circuit de commande 410 pour que ces tensions de commande CMDHS_400 soit utilisées par la puce 402. Des exemples de tels circuits sont décrits en relation avec les figures 6 à 8.

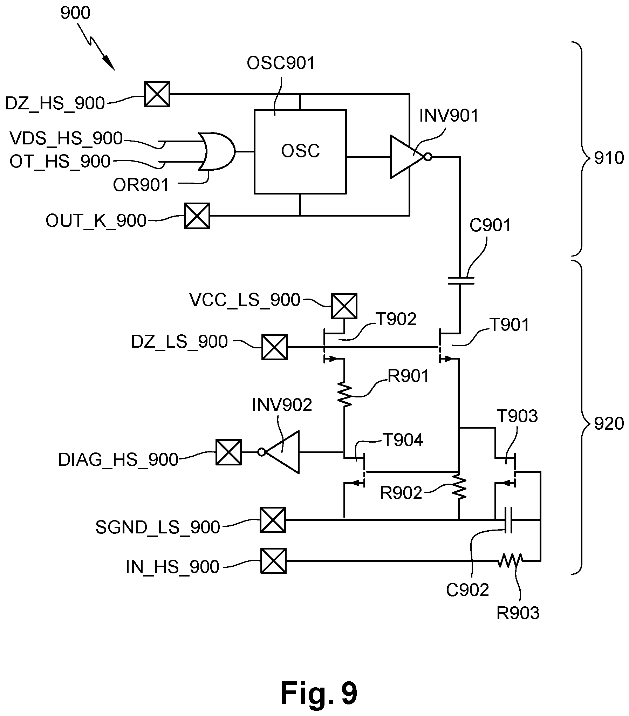

Le circuit de commande 410 est, en outre, adaptée à recevoir des tensions de la part de la puce 402, comme des tensions de diagnostic RSPHS_400. Pour cela et selon un mode de réalisation, la puce 402 comprend des circuits permettant de convertir les tensions de diagnostic RSPHS_400 pour que la puce 401 puisse les recevoir et les transférer au circuit de commande 410. Des exemples de tels circuits sont décrits en relation avec les figures 6 et 9.

Un procédé de conversion de tension utilisant le convertisseur 400 est le suivant. Une tension à convertir est fournie entre les bornes IN_400 et SOURCE_400, et une tension convertie est fournie entre les bornes OUT_400 et SOURCE 400. Un potentiel continu est fourni à la borne DRAIN 400. Les transistors T401 et T402 sont rendues alternativement conducteur et non conducteur par leurs circuits de pilotage en fonction des commandes fournies par le circuit de commande.

La figure 5 représente un exemple pratique du mode de réalisation de convertisseur de tension 400 et de son circuit de commande 410 (µC) décrit en relation avec la figure 4. Plus particulièrement, la figure 5 illustre un convertisseur 500 et son circuit de commande 550 (µC).

Le convertisseur 500 est formé dans et sur une structure du type de la structure 100 décrite en relation avec la figure 1. Plus particulièrement, le convertisseur 500 comprend une majorité de ses composants qui sont formés sur une telle structure et comprend, en outre, une minorité de composants formé sur une structure semiconductrice ne comprenant pas de Nitrure de Gallium (GaN).

Le convertisseur 500 comprend :
- une borne DRAIN_500 (DRAIN) ;
- une borne OUT_500 (OUT) ;
- une borne SOURCE _500 (SOURCE) ;
- une borne SGND_500 (SGND) ;
- une borne VCC_HS_500 (VCC_HS) ;
- une borne DZ_HS_500 (DZ_HS) ;
- une borne VDD_HS _500 (VDD_HS) ;
- une borne de sortie OUT_500 (OUT) adaptée à fournir une tension convertie ;
- une borne de sortie OUT_K_500 (OUT_K) ;
- une borne VCC_LS_500 (VCC_LS) ;
- une borne DZ_LS_500 (DC_LS) ;
- une borne VDD_LS_500 (VDD_LS) ;
- une borne IN_LS_500 (VCC_LS) ;
- une borne IN_HS_500 (IN_HS) ;
- une borne RST_500 (RST) ;
- une borne DIAG_LS_500 (DIAG_LS) ; et
- une borne DIAG_HS_500 (DIAG_HS).

Le convertisseur 500 comprend, en outre une puce 510 du type de la puce 401 décrite en relation avec la figure 4, et une puce 520 du type de la puce 402 décrite en relation avec la figure 4. Ces puces 510 et 520 comprennent des composants qui sont reliés aux différentes bornes du convertisseur décrites précédemment, par exemple, par l'intermédiaire de circuits 503 (ESD) de protection contre les décharges électrostatiques.

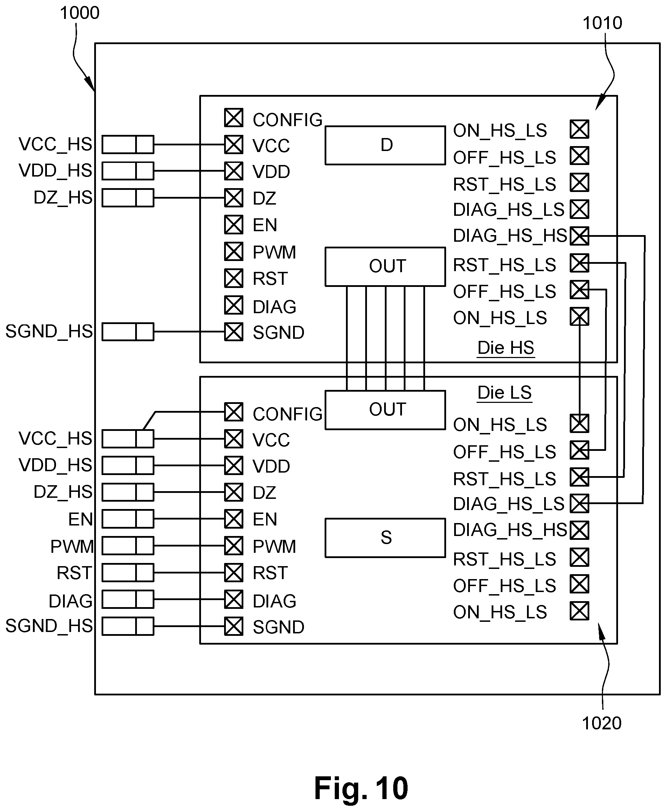

Les puces 510 et 520 comprennent des composants similaires. Plus particulièrement, les puces 510 et 520 peuvent être des puces identiques comprenant, en outre, une borne de configuration (non représentée en figure 5). Cela peut avoir pour avantage d'éviter des problèmes de compatibilité dues à des différences de procédés de fabrication. Cet aspect de l'invention est décrit plus en détail en relation avec la figure 10.

La puce 510 est une puce basse haute tension qui comprend un transistor T510 du type du transistor T401 décrit en relation avec la figure 4. Autrement dit, le transistor T510 est un transistor HEMT de type e-mode. Une borne de drain du transistor T510 est reliée, de préférence connectée, à la borne DRAIN _500 du convertisseur 500. Une première borne de source du transistor T510 est reliée, de préférence connectée, à la borne OUT_500 du convertisseur 500. Une deuxième borne de source du transistor T510 est reliée à la borne OUT_500 du convertisseur 500 par l'intermédiaire d'une résistance R511.

La puce 510 comprend, en outre, un circuit de pilotage du transistor T510 du type du circuit de pilotage D401 décrit en relation avec la figure 4. Le circuit de pilotage du transistor T510 comprend différents éléments parmi lesquels :
- un circuit de commande de grille 511 (DRIVER) du transistor T510 ;
- un ensemble de circuits logiques 512 (LOGIC) ;
- un circuit de régulation de tension 513 (REG) ;
- un circuit de détection de surchauffe 514 (OT) ;
- un circuit d'adaptation de tension 515 (HS HV->LV Shifter) convertissant des hautes tensions en basses tensions ;
- un circuit de conversion de tension 516 (HS LV->HV Shifter) convertissant des basses tensions en hautes tensions ; et
- un circuit de protection 517 (VDS Prot.) contre les surtensions.

Le circuit de commande de grille 511 comprend une sortie reliée, de préférence connectée, à une borne de grille du transistor T510. Le circuit 511 reçoit des tensions de commande de la part de l'ensemble de circuits logique 512. Le circuit 511 est alimenté par un potentiel desservi par la borne VDD_HS_500, et est référencé au potentiel de la borne de sortie OUT_500.

L'ensemble de circuits logiques 512 reçoit des tensions provenant des circuits 514 à 517, et combine ces tensions pour fournir une tension de commande au circuit de commande de grille 511 du transistor T510. L'ensemble 512 est alimenté par un potentiel desservi par le circuit régulateur de tension 513.

Le circuit de régulation de tension 513 comprends deux bornes d'entrée reliées aux bornes VCC_HS_500 et DZ_HS_500, par exemple, par l'intermédiaire de circuits de protection contre les décharges électrostatiques 503. Le circuit 513 comprend deux bornes de sortie, l'une étant reliée à la borne VDD_HS_500, par exemple par l'intermédiaire d'un circuit 503, et l'autre fournissant le potentiel d'alimentation du circuit de commande de grille 511.

Le circuit de détection de surchauffe 514 est un circuit permettant de détecter une augmentation anormale de la température au sein du convertisseur 500, et en particulier au sein de la puce 510. Le circuit 514 est alimenté par le circuit de régulation 513 et fournit une tension de détection de surchauffe à l'ensemble de circuits logiques 512.

Le circuit d'adaptation de tension 515 est, comme dit précédemment, adapté à convertir des hautes tensions en basses tensions. Plus particulièrement, le circuit d'adaptation de tension 515, ou circuit adapteur de tension 515, est adapté à convertir des tensions utilisées par la puce 510 en des tensions utilisables par la puce 520. Le circuit 515 est donc adapté à recevoir, de la part de l'ensemble des circuits logiques 512, des tensions à transmettre à la puce 520, et à transmettre des tensions converties à la puce 520. Un mode de réalisation particulier du circuit 515 est décrit en relation avec la figure 9.

Le circuit de conversion de tension 516 est, comme dit précédemment, adapté à convertir des basses tensions en hautes tensions. Plus particulièrement, le circuit de conversion de tension 516, ou circuit convertisseur de tension 516, ou circuit décaleur de tension 516, est adapté à convertir des tensions utilisées par la puce 520 en des tensions utilisables par la puce 510. Le circuit 516 est donc adapté à recevoir des tensions de la part de la puce 510, et à transmettre des tensions converties à l'ensemble des circuits logiques 512.

Le circuit de protection 517 est adapté à détecter des surtensions ou des surintensités pouvant survenir au niveau du transistor T510. Pour cela, le circuit 517 est alimenté par un potentiel d'alimentation fourni par le circuit de régulation de tension 513. Le circuit 517 est relié, de préférence connecté, à la deuxième borne de source du transistor T510. Le circuit 517 fourni un tension de détection à l'ensemble des circuits logiques 512.

La puce 520 est une puce basse tension qui comprend un transistor T520 du type du transistor T402 décrit en relation avec la figure 4. Autrement dit, le transistor T520 est un transistor HEMT de type e-mode. Une borne de drain du transistor T520 est reliée, de préférence connectée, à la borne de sortie OUT_500 du convertisseur 500. Une première borne de source du transistor T520 est reliée, de préférence connectée, à la borne SOURCE_500 et à la borne SGND_500 du convertisseur 500. Une deuxième borne de source du transistor T520 est reliée à la borne OUT_500 du convertisseur 500 par l'intermédiaire d'une résistance R521.

La puce 520 comprend, en outre, un circuit de pilotage du transistor T520 du type du circuit de pilotage D402 décrit en relation avec la figure 4. Le circuit de pilotage du transistor T520 comprend différents éléments parmi lesquels :
- un circuit de commande de grille 521 (DRIVER) du transistor T520 ;
- un ensemble de circuits logiques 522 (LOGIC) ;
- un circuit de régulation de tension 523 (REG) ;
- un circuit de détection de surchauffe 524 (OT) ;
- un circuit de conversion de tension 525 (LS HV->LV Shifter) convertissant des hautes tensions en basses tensions ;
- un circuit de conversion de tension 526 (LS LV->HV Shifter) convertissant des basses tensions en hautes tensions ; et
- un circuit de protection 527 (VDS Prot.).

Le circuit de commande de grille 521 comprend une sortie reliée, de préférence connectée, à une borne de grille du transistor T520. Le circuit 521 reçoit des tensions de commande de la part de l'ensemble de circuits logique 522. Le circuit 521 est alimenté par un potentiel desservi par la borne VDD_LS_500, et est référencé au potentiel de la borne de sortie SOURCE_500.

L'ensemble de circuits logiques 522 reçoit des tensions provenant des circuits 524 à 527 et des bornes IN_LS_00, IN_HS_500, RST_500 DIAG_LS_500 et DIAG_HS_500, par exemple par l'intermédiaire de circuits 503. L'ensemble de circuits logiques 522 combine ces tensions pour fournir une tension de commande au circuit de commande de grille 21 du transistor T520. L'ensemble 522 est alimenté par un potentiel desservi par le circuit régulateur de tension 523.

Le circuit de régulation de tension 523 comprends deux bornes d'entrée reliées aux bornes VCC_LS_500 et DZ_LS_500, par exemple, par l'intermédiaire de circuits de protection contre les décharges électrostatiques 503. Le circuit 523 comprend deux bornes de sortie, l'une étant reliée à la borne VDD_LS_500, par exemple par l'intermédiaire d'un circuit 503, et l'autre fournissant le potentiel d'alimentation du circuit de commande de grille 521.

Le circuit de détection de surchauffe 524 est un circuit permettant de détecter une augmentation anormale de la température au sein du convertisseur 500, et en particulier de la puce 520. Le circuit 524 est alimenté par le circuit de régulation 523 et fournit une tension de détection de surchauffe à l'ensemble de circuits logiques 522 et à la borne DIAG_LS_500.

Le circuit de conversion de tension 525 est, comme dit précédemment, adapté à convertir des hautes tensions en basses tensions. Plus particulièrement, le circuit de conversion de tension 525, ou circuit convertisseur de tension 525, est adapté à convertir des tensions fournies par la puce 510 en des tensions utilisables par la puce 520. Le circuit 525 est donc adapté à recevoir, de la part de la puce 520, des tensions à transmettre à la puce 510, et à transmettre des tensions converties à l'ensemble de circuits logiques 520.

Le circuit de conversion de tension 526 est, comme dit précédemment, adapté à convertir des basses tensions en hautes tensions. Plus particulièrement, le circuit de conversion de tension 526, ou circuit convertisseur de tension 526, ou circuit décaleur de tension 526, est adapté à convertir des tensions utilisées par la puce 520 en des tensions utilisables par la puce 510. Le circuit 526 est donc adapté à recevoir des tensions de la part de l'ensemble des circuits logiques 522, et à transmettre des tensions converties à la puce 510. Des modes de réalisation de circuits 526 sont décrits en relation avec les figures 6 à 8.

Le circuit de protection 527 est adapté à détecter des surtensions ou des surintensités pouvant survenir au niveau du transistor T520. Pour cela le circuit 527 est alimenté par un potentiel d'alimentation fourni par le circuit de régulation de tension 523. Le circuit 527 est relié, de préférence connecté, à la deuxième borne de source du transistor T520. Le circuit 527 fournit une tension de détection à l'ensemble des circuits logiques 522.

Comme dit précédemment, le convertisseur 500 comprend, en outre, des composants qui ne sont pas formés sur la structure du type de la structure 100 décrite en relation avec la figure 1. Ces composants sont des diodes et des condensateurs qui ne peuvent pas être formés sur une telle structure.

Le convertisseur 500 comprend une diode D501 reliant les bornes VCC_HS_500 et VCC_LS_500. Plus particulièrement, une borne de cathode de la diode D501 est reliée, de préférence connectée, à la borne VCC_HS_500, et une borne d'anode de la diode D501 est reliée, de préférence connectée, à la borne VCC_LS_500.

Le convertisseur 500 comprend, en outre, un condensateur C501 reliant les bornes VCC_HS_500 et OUT_K_500. Plus particulièrement, une première borne du condensateur C501 est reliée, de préférence connectée, à la borne VCC_HS_500, et une deuxième borne du condensateur C501 est reliée, de préférence connectée, à la borne OUT_K_500.

Le convertisseur 500 comprend, en outre, une diode Zener DZ501 reliant les bornes DZ_HS_500 et OUT_K_500.Plus particulièrement, une borne de cathode de la diode DZ501 est reliée, de préférence connectée, à la borne DZ_HS_500, et une borne d'anode de la diode DZ501 est reliée, de préférence connectée, à la borne OUT_K_500.

Le convertisseur 500 comprend, en outre, un condensateur C502 reliant les bornes VDD_HS_500 et OUT_K_500. Plus particulièrement, une première borne du condensateur C502 est reliée, de préférence connectée, à la borne VDD_HS_500, et une deuxième borne du condensateur C502 est reliée, de préférence connectée, à la borne OUT_K_500.

Le convertisseur 500 comprend, en outre, une diode Zener DZ502 reliant les bornes DZ_LS_500 et SGND _500. Plus particulièrement, une borne de cathode de la diode DZ502 est reliée, de préférence connectée, à la borne DZ_LS_500, et une borne d'anode de la diode DZ502 est reliée, de préférence connectée, à la borne SGND_500.

Le convertisseur 500 comprend, en outre, un condensateur C503 reliant les bornes VDD_LS_500 et SGND_500. Plus particulièrement, une première borne du condensateur C503 est reliée, de préférence connectée, à la borne VDD_LS_500, et une deuxième borne du condensateur C503 est reliée, de préférence connectée, à la borne SGND_500.

De plus, et come dit précédemment, est représenté en figure 5, le circuit de commande 550 du convertisseur 500. Selon un exemple, le circuit de commande 550 est un processeur, un microprocesseur, un contrôleur, ou un microcontrôleur. Selon un mode de réalisation, le circuit de commande 550 n'est adapté à communiquer qu'avec la puce 520 et n'est adapté à gérer que des tensions basses, comme la puce 520. Ainsi, le circuit de commande 550 est adapté à fournir des tensions de commande destinées à la puce 520 à la borne IN_LS_500 et à fournir des tensions de commande destinées à la puce 510 à la borne IN_HS_500. Le circuit de commande 550 est, en outre, adapté à fournir une tension de réinitialisation à la borne RST _500. Le circuit de commande 550 est, en outre, adapté à recevoir des tensions de détection de la part de la puce 520 via la borne DIAG_LS_500, et à recevoir des tensions de détection de la part de la puce 510 via la borne DIAG_HS_500. Le circuit de commande est, en outre, référencé à la borne SGND _500. Selon une variante de réalisation, c'est le convertisseur 500 qui est référencé à un potentiel de référence fourni par le circuit de commande 550.

La figure 6 représente un circuit 600 représentant une partie d'un circuit convertisseur de tension du type du convertisseur 400 décrit en relation avec la figure 4 ou du convertisseur 500 décrit en relation avec la figure 5.

Le circuit 600 comprend :
- une borne DRAIN_600 (DRAIN) du type de la borne DRAIN_400 décrite en relation avec la figure 4 ou du type de la borne DRAIN _500 décrite en relation avec la figure 5 ;
- une borne OUT_600 (OUT) du type de la borne OUT_400 décrite en relation avec la figure 4 ou du type de la borne OUT_500 décrite en relation avec la figure 5 ;
- une borne SOURCE_600 (SOURCE) du type de la borne SOURCE_400 décrite en relation avec la figure 4 ou du type de la borne SOURCE _500 décrite en relation avec la figure 5 ;
- une borne SGND_600 (SGND) du type de la borne SOURCEK_400 décrite en relation avec la figure 4 ou du type de la borne SGND_500 décrite en relation avec la figure 5 ;
- une borne IN_LS_600 (VCC_LS) du type de la borne IN_LS_500 décrite en relation avec la figure 5 ;
- une borne IN_HS_600 (IN_HS) du type de la borne IN_HS_500 décrite en relation avec la figure 5 ; et
- une borne DIAG_HS_600 (DIAG _HS) du type de la borne DIAG_HS_500 décrite en relation avec la figure 5.

Comme les convertisseurs 400 et 500, le circuit 600 comprend deux transistors de puissance T601 et T602 HEMT de type e-mode. Plus particulièrement, le transistor T601 est du type du transistors T401 ou du transistor T510, et le transistor T602 est du type du transistors T402 ou du transistor T520. Ainsi, une borne de drain du transistor T601 est reliée, de préférence connectée, à la borne DRAIN_600, et une borne de source du transistor T601 est reliée, de préférence connectée, à la borne OUT_600. Une borne de drain du transistor T602 est reliée, de préférence connectée, à la borne DRAIN_600, et une borne de source du transistor T602 est reliée, de préférence connectée, à la borne OUT_600.

Comme les convertisseurs 400 et 500, le circuit 600 comprend des circuits de pilotage des transistors T601 et T602. Seules certaines parties de ces circuits de pilotage sont représentées.

En particulier, le circuit de pilotage du transistor T601 comprend :
- un circuit de commande de grille D601 du type du circuit de commande de grille D401 décrit en relation avec la figure 4 ou du type du circuit de commande de grille 511 décrit en relation avec la figure 5 ;
- une bascule L601 ;
- un circuit décaleur de tension LS601 (LS_HV) du type du circuit décaleur de tension 516 décrit en relation avec la figure 5 ; et
- un circuit adaptateur de tensions ADAPT601 du type du circuit adaptateur de tension 515 décrit en relation avec la figure 5.

Le circuit de commande de grille D601 comprend une sortie, reliée, de préférence connectée, à la borne de grille du transistor T601. Une entrée de ce circuit D601 est reliée, de référence connectée, à une sortie de la bascule L601. Une entrée de la bascule L601 est reliée, de préférence connectée, à la sortie du circuit décaleur de tension LS601.

Le circuit adaptateur de tensions ADAPT601 est adapté à recevoir, en entrée, un signal de détection de faute FAULT_601 et à le convertir en un signal de détection de faute interprétable par le circuit de pilotage du transistor T602. Pour cela, le circuit ADAPT601 comprend un oscillateur OSC601 (OSC), un circuit tampon B601 (buf) et un condensateur C601. Un exemple du circuit ADAPT601 est décrit plus en détail en relation avec la figure 9.

L'oscillateur OSC601 reçoit, en entrée, le signal de détection de faute FAULT_601, et fournit en sortie un signal oscillant. Plus particulièrement, lorsque le signal FAULT601 est à un premier état, par exemple un état haut, l'oscillateur OSC601 fournit en sortie un signal oscillant, ou tension oscillante, et lorsque le signal FAULT_601 est à un deuxième état, différent du premier état, par exemple un état bas, l'oscillateur OSC601 fournit en sortie un signal constant, c'est-à-dire un signal qui ne présente pas d'oscillation. Selon une variante, lorsque le signal FAULT601 est à un deuxième état, l'oscillateur OSC601 peut fournir en sortie un signal oscillant, ayant une fréquence différente du signal fourni lorsque le signal FAULT_601 est au premier état.

Le circuit tampon B601 reçoit en entrée, le signal fourni par l'oscillateur OSC601, et comprend une sortie inverseuse reliée, de préférence connectée, à une première borne du condensateur C601. Une deuxième borne du condensateur C602 est reliée, de préférence connectée, à un noeud N601.

De façon similaire, le circuit de pilotage du transistor T602 comprend :
- un circuit de commande de grille D602 du type du circuit de commande de grille D402 décrit en relation avec la figure 4 ou du type du circuit de commande de grille 521 décrit en relation avec la figure 5 ;
- un ensemble de circuits logiques Logic602 du type de l'ensemble de circuits logiques 522 décrit en relation avec la figure 5 ;
- un circuit décaleur de tension LS602 (LS_LV) du type du circuit décaleur de tension 526 décrit en relation avec la figure 5 ; et
- un circuit tampon B602 ; et
- une résistance R602.

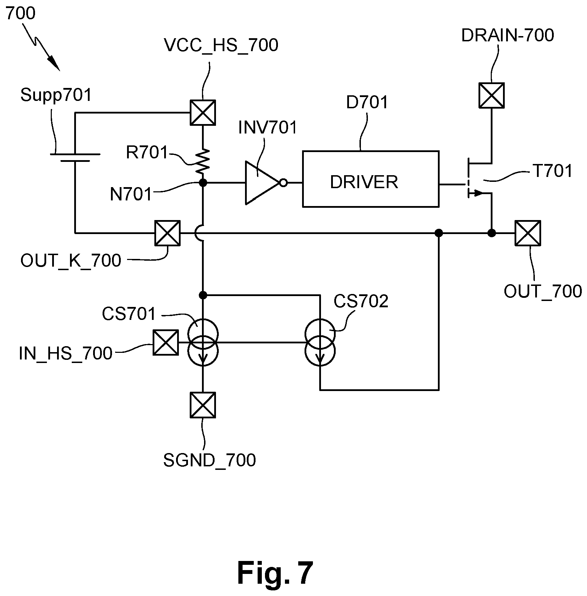

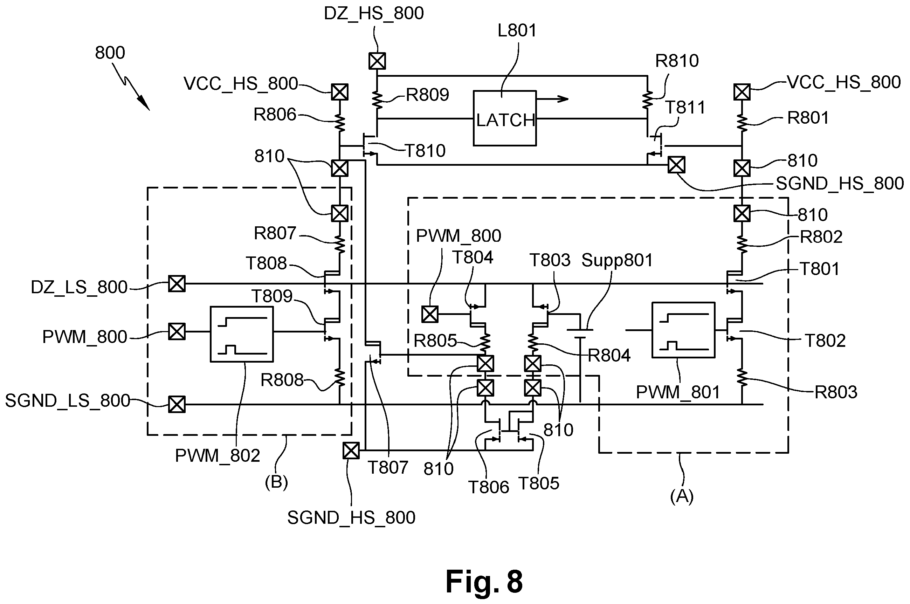

Le circuit de commande de grille D602 comprend une sortie, reliée, de préférence connectée, à la borne de grille du transistor T602. Une entrée de ce circuit D602 est reliée, de préférence connectée, à une sortie de l'ensemble de circuits logiques Logic602. Une première entrée de l'ensemble de circuits logiques Logic602 est reliée, de préférence connectée, à la borne IN_HS_600. Une deuxième entrée de l'ensemble de circuits logiques Logic602 est reliée, de préférence connectée, à la borne IN_LS_600. Le circuit décaleur de tension LS601 comprend une première entrée reliée, de préférence connectée, à la borne IN_HS_600, et une deuxième entrée recevant un potentiel VGS_LS_602. Des exemples du circuit LS602 sont décrits plus en détail en relation avec les figures 7 et 8.

Le circuit tampon B602 comprend une entrée reliée, de préférence connectée, au noeud N601, et comprend une sortie reliée, de préférence connectée, à la borne DIAG_HS_600. La résistance R602 comprend une première borne reliée, de préférence connectée, au noeud N601, et une deuxième borne reliée, de préférence connectée, à la borne SGND_600.

La figure 7 représente un mode de réalisation simplifiée d'un circuit décaleur de tension 700 d'un convertisseur du type des convertisseurs décrits en relation avec les figures 4 à 6.

En figure 7 sont représentées le mode de réalisation du circuit décaleur de tension 700, un transistor de puissance T701 et un circuit de commande grille D701 (DRIVER) dudit transistor de puissance T701.

Comme décrit précédemment, une borne de drain du transistor de puissance T701 est reliée, de préférence connectée, à une borne DRAIN_700, une borne de drain du transistor de puissance T701 est reliée, de préférence connectée, à une borne DRAIN_700, et une borne de source du transistor de puissance T701 est reliée, de préférence connectée, à une borne SOURCE_700. Une borne de grille du transistor T701 reçoit une tension de commande de la part du circuit de commande de grille D701.

Le circuit décaleur de tension 700 comprend une source de tension Supp701 externe reliée entre des bornes VCC_HS_701 et OUT_K_700. Une borne positive de la source Supp701 est reliée, de préférence connectée, à la borne VCC_HS_700, et une borne négative de la source Supp701 est reliée, de préférence connectée, à la borne OUT_K_700.

Le circuit décaleur de tension 700 comprend, en outre, une résistance R701 et un circuit inverseur INV701. Une première borne de la résistance R701 est reliée, de préférence connectée, à la borne VCC_HS_700, et une deuxième borne de la résistance R701 est reliée, de préférence connectée, à un noeud N701. Une borne d'entrée du circuit inverseur INV701 est reliée, de préférence connectée, au noeud N701, et une borne de sortie du circuit inverseur INV701 est reliée, de préférence connectée, à une entrée du circuit de commande grille D701.

Le circuit décaleur de tension 700 comprend, en outre, deux sources de courant CS701 et CS702. La source de courant CS701 est référencée à la borne SGND_700, et comprend une sortie reliée, de préférence connectée, au noeud N701. La source de courant CS702 est référencée à la borne OUT_700, et comprend une sortie reliée, de préférence connectée, au noeud N701. Les sources de courant CS701 et CS702 sont commandées par le potentiel fournie par la borne IN_HS_700.

Le principe de fonctionnement du circuit 700 est le suivant. Les sources de courant CS701 et CS702 sont utilisées pour envoyer des commandes au circuit de commande de grille D701, et in fine au transistor T701. Cependant, le convertisseur peut travailler à très haute tension, et la tension de sortie du convertisseur, c'est-à-dire la tension fournie entre les bornes OUT_700 et SGND_700, peut être comprise entre -50 et 650 V, de préférence entre -15 et 500 V. Les sources de courant CS701 et CS702 ne fournissent pas des courants de même intensité. Quand la tension de sortie est supérieure à une tension de seuil, alors seule la source de courant CS701 est utilisée, et quand la tension de sortie est inférieure à cette tension de seuil, c'est l'autre source de courant, c'est-à-dire la source de courant CS702 qui est utilisée. Selon un exemple, la tension de seuil est comprise entre -5 et 0 V. Selon un exemple, lorsque la tension de sortie est supérieure à -2 V, la source de courant CS701 est utilisée pour transmettre des commandes au circuit D701, et lorsque la tension de sortie est inférieure à -2 V, la source de courant CS702 est utilisée pour transmettre des commandes au circuit D701.

La figure 8 représente un mode de réalisation plus détaillé d'un circuit décaleur de tension 800 d'un convertisseur du type des convertisseurs décrits en relation avec les figures 4 à 6.

Le circuit décaleur de tension 800 est du type du circuit décaleur de tension 526 décrit en relation avec la figure 5 et est formé à cheval sur deux puces du type des puces 510 et 520. Plus particulièrement, les portions de circuits (A) et (B) délimitées par des traits en pointillés sont formées dans une puce adaptée à recevoir des basses tensions, appelée ci-après puce basse tension, du type de la puce 402 décrite en relation avec la figure 4 ou du type de la puce 520 décrit en relation avec la figure 5, le reste des composants est formé dans une puce adaptée à recevoir des hautes tensions, appelée ci-après puce haute tension, du type de la puce 401 décrite en relation avec la figure 4 ou du type de la puce 510 décrit en relation avec la figure 5. Des bornes d'interconnexion 810 des puces haute tension et basse tension sont également représentées en figure 8.

Selon un premier exemple, représenté en figure 8, les puces basse tension et haute tension peuvent être reliées par trois ensembles de bornes d'interconnexion 810.

Selon un deuxième exemple, non représenté en figure 8, les puces basse tension et haute tension peuvent être reliées par seulement deux ensembles de bornes d'interconnexion 810. Un avantage de cette exemple est qu'il permet de réduire la taille des substrats sur lesquels les puces haute tension et basse tension sont formées. Dans ce cas, à titre d'exemple, les transistors T805 à T807 décrits ci-après font partie de la puce basse tension.

Le circuit 800 comprend :
- une borne VCC_HS_800 du type de la borne VCC_HS_500 décrite en relation avec la figure 5 ou du type de la borne VCC_HS_700 décrite en relation avec la figure 7, la borne VCC_HS_800 formant une borne d'alimentation de la puce haute tension ;
- une borne SGND_HS_800 du type de la borne OUT_K_500 décrite en relation avec la figure 5, la borne SGND_HS_800 formant une borne de référence de la puce haute tension ;
- une borne SGND_LS_800 du type de la borne SGND_500 décrite en relation avec la figure 5, ou du type de la borne SGND_700 décrite en relation avec la figure 7, la borne SGND_LS_800 formant une borne de référence de la puce basse tension ;
- une borne DZ_HS_800 du type de la borne DZ_HS_500 décrite en relation avec la figure 5 ;
- une borne DZ_LS_800 du type de la borne DZ_LS_500 décrite en relation avec la figure 5 ; et
- une borne PWM_800 (SOURCE).

Le circuit 800 comprend, en outre, entre les bornes VCC_HS_800 et SGND_LS_800 trois résistances T801, R802 et R803, et deux transistors T801 et T802 HEMT de type e-mode. Une première borne de la résistance R801 est reliée, de préférence connectée, à la borne VCC_HS_800, et une deuxième borne de la résistance R801 est reliée, de préférence connectée, à une première borne de la résistance R802. Une deuxième borne de la résistance R802 est reliée, de préférence connectée, à une borne de drain du transistor T801. Une borne de source du transistor T801 est reliée, de préférence connectée, à une borne de drain du transistor T802. Une borne de source du transistor T802 est reliée, de préférence connectée, à une première borne de la résistance R803. Une deuxième borne de la résistance R803 est reliée, de préférence connectée, à la borne SGND_LS_800. Une borne de grille du transistor T801 est reliée, de préférence connectée, à la borne DZ_LS_800.

Le circuit 800 comprend, en outre, un circuit PWM801 de modulation de largeur d'impulsion. Une entrée de ce circuit PWM801 est adaptée à recevoir un signal de commande fournit par la borne PWM_800 qui a été inversé. une sortie de ce circuit PWM801 est reliée, de préférence connectée, à la borne de grille du transistor T802.

Le circuit 800 comprend, en outre, quatre transistors T803, T804, T805 et T806 HEMT de type e-mode, deux résistances R804 et R805 et une source de tension Supp801. Une borne de source du transistor T803 est reliée, de préférence connectée, à la borne DZ_LS_800, et une borne de drain du transistor T803 est reliée, de préférence connectée, à une première borne de la résistance R804. Une deuxième borne de la résistance R804 est reliée, de préférence connectée à une borne de drain du transistor T805 et à une borne de grille du transistor T805. Une borne de source du transistor T804 est reliée, de préférence connectée, à la borne DZ_LS_800, et une borne de drain du transistor T804 est reliée, de préférence connectée, à une première borne de la résistance R805. Une deuxième borne de la résistance R805 est reliée, de préférence connectée à une borne de drain du transistor T806 et à une borne de grille du transistor T806. Les bornes de source des transistors T805 et T806 sont reliées entre elles, et à la borne SGND_HS_800. Une borne de grille du transistor reçoit une tension de la part de la source de tension Supp801. La source de tension Supp801 est référencée à la borne SGND_LS_800. Une borne de grille du transistor T804 est reliée, de préférence connectée, à la borne PWM_800.

Le circuit 800 comprend, en outre, un transistor HEMT de type e-mode. Une borne de source du transistor T807 est reliée, de préférence connectée, à la borne SGND_HS_800. Une borne de grille du transistor T807 est reliée à la borne de drain du transistor T806. Le transistor T807 est adapté à fournir un courant, et est considéré comme une sortie d'une source de courant. Selon un mode de réalisation, le transistor T807 forme une sortie de la source de courant CS702 décrite en relation avec la figure 7.

Le circuit 800 comprend, en outre, entre les bornes VCC_HS_800 et SGND_LS_800 trois résistances R806, R807 et R808, et deux transistors T808 et T809 HEMT de type e-mode. Une première borne de la résistance R806 est reliée, de préférence connectée, à la borne VCC_HS_800, et une deuxième borne de la résistance R806 est reliée, de préférence connectée, à une première borne de la résistance R807. Une deuxième borne de la résistance R807 est reliée, de préférence connectée, à une borne de drain du transistor T808. Une borne de source du transistor T808 est reliée, de préférence connectée, à une borne de drain du transistor T809. Une borne de source du transistor T809 est reliée, de préférence connectée, à une première borne de la résistance R808. Une deuxième borne de la résistance R808 est reliée, de préférence connectée, à la borne SGND_LS_800. Une borne de grille du transistor T808 est reliée, de préférence connectée, à la borne DZ_LS_800. Les transistors T808 et T809 sont adaptés à fournir un courant, et sont considérés comme une sortie d'une source de courant. Selon un mode de réalisation, les transistors T808 et T809 forment une sortie de la source de courant CS701 décrite en relation avec la figure 7.

Le circuit 800 comprend, en outre, un circuit PWM802 de modulation de largeur d'impulsion. Une entrée de ce circuit PWM802 est adaptée à recevoir un signal de commande fournit par la borne PWM_800. une sortie de ce circuit PWM802 est reliée, de préférence connectée, à la borne de grille du transistor T809.

Le circuit 800 comprend, en outre, une bascule L801 (LATCH) du type de la bascule L601 décrite en relation avec la figure 6, deux résistances R809 et R810, et deux transistors T810 et T811 HEMT de type e-mode. Une première borne de la résistance R809 est reliée, de préférence connectée, à la borne DZ_HS_800, et une deuxième borne de la résistance R809 est reliée, de préférence connectée, à une borne d'entrée de la bascule L801 et à une borne de drain du transistor T810. Une borne de source du transistor T810 est reliée, de préférence connectée, à la borne SGND_HS_800. Une borne de grille du transistor T810 est reliée, de préférence connectée, à la deuxième borne de la résistance R806, c'est-à-dire à la borne de drain du transistor T807. Une première borne de la résistance R810 est reliée, de préférence connectée, à la borne DZ_HS_800, et une deuxième borne de la résistance R810 est reliée, de préférence connectée, à une première borne de sortie de la bascule L801 et à une borne de drain du transistor T811. Une borne de source du transistor T811 est reliée, de préférence connectée, à la borne SGND_HS_800. Une borne de grille du transistor T811 est reliée, de préférence connectée, à la deuxième borne de la résistance R801. Une deuxième borne de sortie de la bascule L801 est adaptée à fournir une tension de commande à un circuit de commande de grille du type du circuit D701 décrit en relation la figure 7.

La figure 9 représente un mode de réalisation plus détaillé d'un circuit adaptateur de tension 900 d'un convertisseur du type des convertisseurs décrits en relation avec les figures 4 à 6.

Le circuit adaptateur de tension 900 est du type du circuit adaptateur 515 décrit en relation avec la figure 5, et plus particulièrement un circuit convertisseur du type du circuit adaptateur ADAPT601 décrit en relation avec la figure 6.

Le circuit adaptateur de tension 900 est du type du circuit adaptateur de tension 515 décrit en relation avec la figure 5 et est formé à cheval sur deux puces du type des puces 510 et 520. Plus particulièrement, les portions de circuits 920 sont formées dans une puce adaptée à recevoir des basses tensions, appelée ci-après puce basse tension, du type de la puce 402 décrite en relation avec la figure 4 ou du type de la puce 520 décrit en relation avec la figure 5, le reste des composants, référencé 910 est formé dans une puce adaptée à recevoir des hautes tensions, appelée ci-après puce haute tension, du type de la puce 401 décrite en relation avec la figure 4 ou du type de la puce 510 décrit en relation avec la figure 5.

Le circuit 900 comprend :
- une borne DZ_HS_900 du type de la borne DZ_HS_500 décrite en relation avec la figure 5 ;
- une borne DZ_LS_900 du type de la borne DZ_LS_500 décrite en relation avec la figure 5 ;
- une borne OUT_K_900 du type de la borne OUT_K_500 décrite en relation avec la figure 5 ;
- une borne SGND_LS_900 du type de la borne SGND_500 décrite en relation avec la figure 5 ;
- une borne IN_HS_900 du type de la borne IN_HS_500 décrite en relation avec la figure 5 ; et
- une borne DIAG_HS_900 du type de la borne DIAG_HS_500 décrite en relation avec la figure 5.

Le circuit 900 comprend un oscillateur OSC901 (OSC), ou circuit oscillant OSC901, une porte logique OR901 de type OU (OR) et un circuit inverseur INV901. L'oscillateur OSC901 est alimenté par un potentiel fourni par la borne DZ_HS_900, et est référencé à un potentiel fourni par la borne OUT_K_900. Une borne de commande de l'oscillateur OSC901 est reliée, de préférence connectée, à la sortie de la porte logique OR901. Une première borne d'entrée de la porte logique OR901 est adaptée à recevoir une tension de détection d'une surtension VDS_HS_900. Une deuxième borne d'entrée de la porte logique OR901 est adaptée à recevoir une tension de détection de surchauffe OT_HS_900. Une sortie de l'oscillateur OSC901 est reliée, de préférence connectée, à une entrée du circuit inverseur INV901. Le circuit inverseur INV901 est alimenté par un potentiel fourni par la borne DZ_HS_900, et est référencé à un potentiel fourni par la borne OUT_K_900.

Le circuit 900 comprend, en outre, un condensateur C901, un transistor T901 HEMT de type e-mode, et une résistance R901. Une première borne du condensateur C901 est reliée, de préférence connectée, à la sortie du circuit inverseur INV901, et une deuxième borne du condensateur C901 est reliée, de préférence connectée, à une borne de drain du transistor T901. Une borne de source du transistor T901 est reliée, de préférence connectée, à une première borne de la résistance R901. Une deuxième borne de la résistance R901 est reliée, de préférence connectée, à la borne SGND_LS_900. Une borne de grille du transistor T901 est reliée, de préférence connectée, à la borne DZ_LS_900.

Le circuit 900 comprend, en outre, deux transistors T902 et T904 HEMT de type e-mode et une résistance R902. Une borne de drain du transistor T902 est reliée, de préférence connectée, à la borne VCC_LS_900, et une borne de source du transistor T902 est reliée, de préférence connectée, à une première borne de la résistance R902. Une deuxième borne de la résistance R902 est reliée, de préférence connectée, à la borne de drain du transistor T904. Une borne de source du transistor T904 est reliée, de préférence connectée, à la borne SGND_LS_900.

Le circuit 900 comprend, en outre, un circuit inverseur INV902. Une entrée du circuit INV902 est reliée, de préférence connectée, à la borne de drain du transistor T904. Une borne de sortie du circuit INV902 est reliée, de préférence connectée, à la borne DIAG_HS_900.

Le circuit 900 comprend, en outre, un transistor T903, un condensateur C902 et une résistance R903. Une borne de drain du transistor T903 est reliée, de préférence connectée, à la borne de source du transistor T901, et une borne de drain du transistor T903 est reliée, de préférence connectée, à la borne SGND_LS_900. La borne de grille du transistor T903 est reliée, de préférence connectée, à une première borne du condensateur C902. Une deuxième borne du condensateur C902 est reliée, de préférence connectée, à la borne SGND_LS_900. Une première borne de la résistance R903 est reliée, de préférence connectée, à la grille du transistor T903, et une deuxième borne de la résistance R903 est reliée, de préférence connectée à la borne IN_HS_900.

Le fonctionnement du circuit 900 est le suivant. L'oscillateur OSC901 reçoit, en entrée, un signal de détection de faute obtenu à partir des tensions VDS_HS_900 et OT_HS_901, et fournit en sortie un signal oscillant. Plus particulièrement, lorsque le signal de détection de faute est à un premier état, par exemple un état haut, l'oscillateur OSC901 fournit en sortie un signal oscillant, ou tension oscillante, et lorsque le signal de détection de faute est à un deuxième état, différent du premier état, par exemple un état bas, l'oscillateur OSC901 fournit en sortie un signal constant, c'est-à-dire un signal qui ne présente pas d'oscillation.

Plus particulièrement, l'élément clé du circuit 900 est le condensateur C901, c'est ce condensateur C901 qui transfert l'information par couplage capacitif de la puce haute tension vers la puce basse tension. Le transfert d'information est réalisé avec une tension différentiel basse tension, par exemple de l'ordre de 6 V, sur une tension du mode commun de 400 V. De plus, selon un mode de réalisation, le condensateur C901 est formé dans et sur la puce basse tension, par entre des niveaux de métallisation, par exemple entre les deuxième et troisième niveaux de métallisation.

La figure 10 représente, très schématiquement et sous forme de bloc, un mode de réalisation d'un convertisseur 1000 du type des convertisseurs décrits en relation avec les figures 4 à 6.

Comme décrit en relation avec la figure 4, le convertisseur 1000 comprend deux puces 1010 (Die HS) et 1020 (Die LS) utilisant des structures comprenant du nitrure de Gallium (GaN), comme une structure du type de la structure 100 décrite en relation avec la figure 1.

Selon un mode de réalisation, les puces 1010 et 1020 sont identiques, c'est-à-dire qu'elles ont été fabriquées en utilisant un même procédé de fabrication et qu'elles ont été fabriquées sur une même structure. Dit autrement, les puces 1010 et 1020 comprennent les mêmes circuits et composants électroniques. Seul le placement des composants peut différer d'une puce à l'autre. De plus, selon un mode de réalisation, les puces 1010 et 1020 sont toutes deux adaptés à être une puce haute tension ou une puce basse tension.

Chaque puce 1010, 1020 comprend une borne principale, noté D pour la puce 1010 et S pour la puce 1020, et une borne de communication OUT. Selon un mode de réalisation, les puces 1010 et 1020 comprennent chacune une borne de configuration CONFIG utilisée pour définir le rôle de chaque puce. En particulier, la borne CONFIG permet de configurer une puce 1010, 1020 en une puce haute tension ou en une puce basse tension.

Selon l'exemple illustré en figure 10, chaque puce 1010, 1020 comprend, en outre, les bornes suivantes :
- une borne ON_HS_LS ;
- une borne OFF_HS_LS ;
- une borne RST_HS_LS ;
- une borne DIAG_HS_LS ;
- une borne RST_HS_LS ;
- une borne OFF_HS_HS ;
- une borne ON_HS_HS ;
- une borne VCC ;
- une borne VDD ;
- une borne DZ ;
- une borne EN ;
- une borne PWM ;
- une borne RST ;
- une borne DIAG ; et
- une borne SGND.

Pour former le convertisseur 1000, les puces 1010 et 1020 sont assemblées sur une même plaque. D'autres composants électroniques peuvent être ajoutés au substrat, comme décrit en relation avec la figure 5.

Les puces 1010 et 1020 sont reliées entre elle, par exemple en reliant leurs bornes de communication OUT entre elles. Selon un exemple, les bornes ON_HS_LS des puces 1010 et 1020 sont également reliées entre elles. Selon un exemple, les bornes OFF_HS_LS des puces 1010 et 1020 sont également reliées entre elles. Selon un exemple, les bornes RST_HS_LS des puces 1010 et 1020 sont également reliées entre elles. Selon un exemple, les bornes DIAG_HS_LS des puces 1010 et 1020 sont également reliées entre elles.

Des bornes de connexion du convertisseur 1000 sont, en outre, reliées aux bornes des puces 1010 et 1020. Selon un exemple :
- une borne VCC_HS du convertisseur 1000 est reliée, de préférence connectée, à la borne VCC de la puce 1010 ;
- une borne VDD_HS du convertisseur 1000 est reliée, de préférence connectée, à la borne VDD de la puce 1010 ;
- une borne DZ_HS du convertisseur 1000 est reliée, de préférence connectée, à la borne DZ de la puce 1010 ;
- une borne SGND_HS du convertisseur 1000 est reliée, de préférence connectée, à la borne SGND de la puce 1010 ;
- une borne VCC_LS du convertisseur 1000 est reliée, de préférence connectée, à la borne VCC de la puce 1020 ;
- une borne VDD_LS du convertisseur 1000 est reliée, de préférence connectée, à la borne VDD de la puce 1020 ;
- une borne DZ_LS du convertisseur 1000 est reliée, de préférence connectée, à la borne DZ de la puce 1020 ;
- une borne EN du convertisseur 1000 est reliée, de préférence connectée, à la borne EN de la puce 1020 ;
- une borne PWM du convertisseur 1000 est reliée, de préférence connectée, à la borne PWM de la puce 1020 ;
- une borne RST du convertisseur 1000 est reliée, de préférence connectée, à la borne RST de la puce 1020 ;
- une borne DIAG du convertisseur 1000 est reliée, de préférence connectée, à la borne DIAG de la puce 1020 ; et
- une borne SGND_LS du convertisseur 1000 est reliée, de préférence connectée, à la borne SGND de la puce 1020.

Ainsi, un procédé de fabrication du convertisseur 1000 comprend deux étapes de fabrication identiques des première et deuxième puces. Selon un exemple, le procédé comprend en outre, une étape de configuration utilisant les bornes CONFIG des puces 1010 et 1020.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Convertisseur de tension (400 ; 500 ; 600 ; 1000) formé dans et sur un substrat semiconducteur monolithique (101) ayant une face recouverte d'une couche de Nitrure de Gallium (102), comprenant :
- une première puce (401 ; 510 ; 1010) comportant un premier transistor (T401 ; T510 ; T601) de puissance HEMT de type e-mode et un premier circuit de commande (D401) dudit premier transistor (T401 ; T510 ; T601) ; et
- une deuxième puce (402 ; 520 ; 1020) comportant un deuxième transistor (T402 ; T520 ; T602) de puissance HEMT de type e-mode et un deuxième circuit de commande (D402) dudit deuxième transistor (T402 ; T520 ; T602), et étant adapté à transmettre au moins une première tension reçue de la part d'un troisième circuit de commande (410 ; 550) à ladite deuxième puce (402 ; 520 ; 1020) ;
dans lequel ladite deuxième puce (402 ; 520 ; 1020) comprend un premier circuit décaleur de tension (526 ; ADAPT601 ; 700) adapté à convertir ladite au moins une première tension en une deuxième tension,
ledit premier circuit décaleur de tension (526 ; LS601 ; 700) comprenant une première source de courant (CS701) adaptée à être utilisée lorsqu'une troisième tension de sortie dudit convertisseur (400 ; 500 ; 600 ; 1000) est inférieure à une quatrième tension de seuil, et une deuxième source de courant (CS702) adaptée à être utilisée lorsque ladite troisième tension de sortie est supérieure à ladite quatrième tension de seuil.

2. Convertisseur selon la revendication 1, dans lequel les première et deuxième sources de courant (CS701, CS702) sont utilisées pour fournir une tension de commande audit premier transistor (T401 ; T510 ; T601).

3. Convertisseur selon la revendication 1 ou 2, dans lequel ladite quatrième tension de seuil est comprise entre -5 et 0 V.

4. Convertisseur selon la revendication 3, dans lequel ladite quatrième tension de seuil est égale à -2 V.

5. Convertisseur selon l'une quelconque des revendications 1 à 4, dans lequel la première puce (401 ; 510 ; 1010) est adaptée à recevoir des hautes tensions, et la deuxième puce (402 ; 520 ; 1020) est adaptée à recevoir des basses tensions.

6. Convertisseur selon l'une quelconque des revendications 1 à 5, dans lequel ladite première puce (401 ; 510 ; 1010) comprend, en outre, un quatrième circuit adaptateur de tension (515 ; ADAPT601 ; 900) adapté à convertir au moins une cinquième tension de ladite première puce (401 ; 510 ; 1010) en une sixième tension de diagnostic pour la transmettre à ladite deuxième puce (402 ; 520 ; 1020), ledit quatrième circuit adaptateur de tension (515 ; ADAPT601 ; 900) comprenant un oscillateur (OSC601 ; OSC901) étant configuré pour faire osciller ladite sixième tension lorsque ladite cinquième tension est à un premier état.

7. Convertisseur selon la revendication 6, dans lequel ledit oscillateur (OSC601 ; OSC901) étant configuré pour ne pas faire osciller ladite sixième tension lorsque ladite cinquième tension est à un deuxième état différent du premier état.

8. Convertisseur selon l'une quelconque des revendications 1 à 7, dans lequel lesdites première et deuxième puces (401, 402 ; 510, 520 ; 1010, 1020) sont des puces identiques.

9. Convertisseur selon la revendication 8, dans lequel lesdites première et deuxième puces 401, 402 ; 510, 520 ; 1010, 1020) comprennent chacune une borne de configuration (CONFIG) leur permettant de définir leur rôle dans ledit convertisseur.

10. Convertisseur selon l'une quelconque des revendications 1 à 9, étant une alimentation à découpage.

11. Convertisseur selon l'une quelconque des revendications 1 à 10, étant une alimentation à découpage de type convertisseur boost.

12. Procédé de conversion d'une septième tension d'entrée en une troisième tension de sortie utilisant un convertisseur de tension (400 ; 500 ; 600 ; 1000) formé dans et sur un substrat semiconducteur monolithique (101) ayant une face recouverte d'une couche de Nitrure de Gallium (102), comprenant :
- une première puce (401 ; 510 ; 1010) comportant un premier transistor (T401 ; T510 ; T601) de puissance HEMT de type e-mode et un premier circuit de commande (D401) dudit premier transistor (T401 ; T510 ; T601) ; et
- une deuxième puce (402 ; 520 ; 1020) comportant un deuxième transistor (T402 ; T520 ; T602) de puissance HEMT de type e-mode et un deuxième circuit de commande (D402) dudit deuxième transistor (T402 ; T520 ; T602), et étant adapté à transmettre au moins une première tension reçue de la part d'un troisième circuit de commande (410 ; 550) à ladite deuxième puce (402 ; 520 ; 1020) ;
dans lequel ladite deuxième puce (402 ; 520 ; 1020) comprend un premier circuit convertisseur de tension (526 ; ADAPT601 ; 700) adapté à convertir ladite au moins une première tension en une deuxième tension,
ledit premier circuit convertisseur de tension (526 ; LS601 ; 700) comprenant une première source de courant (CS701) adaptée à être utilisée lorsqu'une troisième tension de sortie dudit convertisseur (400 ; 500 ; 600 ; 1000) est inférieure à une quatrième tension de seuil, et une deuxième source de courant (CS702) adaptée à être utilisée lorsque ladite troisième tension de sortie est supérieure à ladite quatrième tension de seuil.

13. Procédé de fabrication d'un convertisseur de tension (400 ; 500 ; 600 ; 1000) comprenant :
- une première puce (401 ; 510 ; 1010) comportant un premier transistor (T401 ; T510 ; T601) de puissance HEMT de type e-mode et un premier circuit de commande dudit premier transistor (T401 ; T510 ; T601) ; et
- une deuxième puce (402 ; 520 ; 1020) comportant un deuxième transistor (T402 ; T520 ; T602) de puissance HEMT de type e-mode et un deuxième circuit de commande (D402 ; 521 ; D602) dudit deuxième transistor (T402 ; T520 ; T602) ; comprenant deux étapes de fabrication identiques des première et deuxième puces (401, 402 ; 510, 520 ; 1010, 1020).

14. Procédé selon la revendication 13, comprenant, en outre, une étape de configuration des première et deuxième puces (401, 402 ; 510, 520 ; 1010, 1020) qui est successive aux deux étapes de fabrication.

15. Procédé selon la revendication 14, dans lequel pendant l'étape de configuration une borne de configuration (CONFIG) desdites première et deuxième puces (401, 402 ; 510, 520 ; 1010, 1020) est utilisée.
